Europäisches Patentamt

(19) European Patent Office

Office européen des brevets

(11) Veröffentlichungsnummer: **0 264 463**
**B1**

(12) **EUROPÄISCHE PATENTSCHRIFT**

(45) Veröffentlichungstag der Patentschrift:
08.03.89

(21) Anmeldenummer: **86114376.6**

(22) Anmeldetag: **17.10.86**

(51) Int. Cl.⁴: **C22C 9/00**, C22F 1/08,
H01L 23/00

(54) Kupfer-Chrom-Titan-Silizium-Legierung, Verfahren zu ihrer Herstellung und ihre Verwendung.

(43) Veröffentlichungstag der Anmeldung:
27.04.88 Patentblatt 88/17

(45) Bekanntmachung des Hinweises auf die Patenterteilung:
08.03.89 Patentblatt 89/10

(84) Benannte Vertragsstaaten:
CH DE FR GB IT LI SE

(56) Entgegenhaltungen:
DE-A- 1 758 055
DE-C- 3 421 198
DE-C- 3 527 341
GB-A- 535 921
US-A- 2 189 198
US-A- 4 260 435

(73) Patentinhaber: Wieland-Werke AG,
Postfach 4240 Graf-Arco-Strasse, D-7900 Ulm
(Donau)(DE)

(72) Erfinder: Dürrschnabel, Wolfgang, Dr. rer. nat., Dipl.-Ing.,
Am Schlossberg 4, D-7919 Bellenberg(DE)
Erfinder: Puckert, Franz, Dr. rer. nat., Dipl.-Ing.,
Giessenweg 11, D-7901 Illerrieden(DE)
Erfinder: Bletschacher, Max, Dipl.-Ing., Hangstrasse 22,
D-7917 Vöhringen-Illerberg(DE)

**Beschreibung**

Die Erfindung betrifft eine Kupfer-Chrom-Titan-Silizium-Legierung, ein Verfahren zu ihrer Herstellung und ihre Verwendung.

Es besteht ein großer Bedarf an Kupfer-Legierungen für elektrische Anwendungszwecke. Diese Legierungen werden unter anderem benötigt als Werkstoffe für elektronische Bauteile, insbesondere Halbleiterträger (sog. lead frames) für Transistoren, integrierte Schaltungen, für Steckverbinder und Teile für die Autoelektrik.

Werkstoffe für elektronische Bauteile, insbesondere Halbleiterträger der genannten Art, müssen besondere Eigenschaftskombinationen aufweisen:

a) die elektrische und thermische Leitfähigkeit sollte möglichst hoch sein (etwa oberhalb 50% IACS);

b) es wird eine hohe mechanische Festigkeit bei gleichzeitig ausreichender Biegbarkeit gefordert;

c) es wird darüber hinaus eine hohe Erweichungsbeständigkeit gefordert;

d) es werden in zunehmendem Maße homogene Werkstoffe gefordert, d. h. Werkstoffe, deren Gefüge keine groben Ausscheidungen oder Einschlüsse enthält. Damit erreicht man einerseits eine einwandfreie Verbindung zwischen den sogenannten Bonddrähten und dem Halbleiterträger und andererseits, wenn für die weiteren Verarbeitungsschritte notwendig, eine gute galvanische oder chemische Oberflächenveredelbarkeit.

e) um Bandmaterial für den obengenannten Einsatzzweck auf wirtschaftliche Weise herstellen zu können, ist es zudem wichtig, daß die Legierungen gut kaltverformt und zu Bändern ausgewalzt werden können.

Für den genannten Anwendungsfall werden bisher in großem Umfang u. a. Eisen-Nickel-Legierungen oder Kupfer-Legierungen, wie beispielsweise CuFe2P (C 19400) oder CuFeSnP (C 19520) eingesetzt. Auch bei den genannten Kupferlegierungen lassen insbesondere noch die elektrische Leitfähigkeit und wegen des relativ hohen Legierungsanteils, der teilweise zu unerwünscht groben Ausscheidungen führt, auch die Homogenität der Werkstoffe zu wünschen übrig.

Für Anschlußteile in der Autoelektrik wird wegen der hohen Strombelastung ein Werkstoff mit möglichst hoher elektrischer und thermischer Leitfähigkeit bei gleichzeitig hoher Festigkeit und damit ausreichender mechanischer Stabilität sowie gegenüber Messinglegierungen verbesserter Korrosionsbeständigkeit gefordert. Darüberhinaus sollte der Werkstoff kostengünstig herzustellen sein.

Der Erfindung liegt daher die Aufgabe zugrunde, eine Kupfer-Legierung anzugeben, welche insbesondere für die genannten Anwendungsgebiete besonders günstige Eigenschaften bei einem vergleichsweise niedrigen Preis aufweist.

Die Aufgabe wird erfindungsgemäß durch eine Kupfer-Chrom-Titan-Silizium-Legierung gelöst, die dadurch gekennzeichnet ist, daß sie aus 0,10 bis 0,50% Chrom; 0,01 bis 0,25% Titan; Silizium; Rest Kupfer und üblichen Verunreinigungen besteht, wobei der Siliziumgehalt mehr als das 0,1-fache des Titangehalts beträgt und bis zu einem Titangehalt von 0,099% durch die Gleichung:

Siliziumgehalt (%) = 0,05% + 0,5 Titangehalt (%),

und bei einem Titangehalt von mehr als 0,099% durch die Gleichung:

Siliziumgehalt (%) = 0,149% −0,5 Titangehalt (%)

begrenzt ist (die Prozentangaben beziehen sich dabei auf das Gew.).

Die vorteilhaften Eigenschaften der erfindungsgemäßen Legierung werden weiter unten anhand eines Ausführungsbeispiels näher erörtert. Die Legierung ist zudem preisgünstig durch den geringen Gehalt an relativ billigen Legierungselementen und durch die einfache Fertigung.

Aus der DE-OS 1 758 055 läßt sich zwar eine Legierung mit 0,3 bis 7% Chrom und/oder Titan und 0,1 bis 3% Silizium herleiten, der Fachmann erhält jedoch daraus keine Anregung, den Silizium-Gehalt unter 0,1% abzusenken. Solch geringe Silizium-Gehalte galten bislang eher als nachteilig für die Eigenschaftskombinationen dieser Legierungsgruppe.

Es ist zwar ferner aus der US-PS 2 189 198 eine Kupfer-Chrom-Titan-Silizium-Legierung mit etwa 0,1 bis 0,6% Chrom, etwa 0,6 bis 1,5% Titan und 0,1 bis 0,6% Silizium bekannt, besonders gute Ergebnisse werden dort jedoch mit einem Titan-Gehalt von etwa 1% erzielt, so daß es insbesondere nicht nahelag, einen Titan-Gehalt unter 0,6% zu wählen. Zudem sollen diese Legierungen hauptsächlich als Gußwerkstoffe Verwendung finden. Die günstigsten Eigenschaftskombinationen lassen sich nur erzielen, wenn von einer hohen Lösungstemperatur abgeschreckt wird und danach bei mäßigen Temperaturen sehr lange Zeiten von über 16 h eine Auslagerungsbehandlung stattfindet. Diese sehr unwirtschaftliche Vorgehensweise führt zudem nur zu elektrischen Leitfähigkeitswerten von etwa 50% IACS und Härtewerten von 109 HB (Brinell-Härte), diese Legierungen können deswegen für den vorgenannten Anwendungszweck nicht befriedigen.

Nach besonderen Ausführungsformen der vorliegenden Erfindung gemäß Anspruch 2 und 3 werden hohe bis sehr hohe Leitfähigkeiten bei zumindest guten Festigkeiten bzw. sehr hohe Festigkeiten bei zumindest guten Leitfähigkeiten erzielt.

Bei einer Legierungszusammensetzung nach Anspruch 4 werden sehr hohe Leitfähigkeiten bei guten Festigkeiten erzielt, bei einer Legierungszusammensetzung nach Anspruch 5 hohe Leitfähigkeiten bei gleichzeitig hohen Festigkeiten.

Gegenstand der Erfindung ist weiterhin ein Verfahren zur Herstellung der erfindungsgemäßen Legierung. Zur Erzielung günstiger Eingenschaftskombinationen wird die Legierung nach dem Gießen vorzugsweise bei Temperaturen von 850° bis 950°C zwischen 1 und 24 Stunden homogenisiert, bei Temperaturen von 600° bis 830°C in einem oder mehreren Stichen warmgewalzt und mit einer Abkühlgeschwindigkeit zwischen 10°C pro Minute und 2000°C pro Minute auf Raumtemperatur abgekühlt.

Es empfiehlt sich, das Warmwalzen insbesondere bei 650° bis 750° C, das Abkühlen insbesondere mit einer Abkühlgeschwindigkeit zwischen 50°C pro Minute und 1000°C pro Minute durchzuführen. Nach einer bevorzugten Ausführungsform des Verfahrens wird nach dem Abkühlen mit einem Verformungsgrad bis zu 95% in einem oder mehreren Stichen kaltgewalzt. Zwischen den Kaltwalzstichen kann die Legierung vorzugsweise zur Erzielung einer erfindungsgemäßen, gleichmäßigen Dispersion der Ausscheidungsphase bis max. 10 Stunden geglüht werden.

Zur Erzielung der gewünschten Eigenschaften empfiehlt sich eine Glühung als Bund im Haubenofen bei Temperaturen von 350° bis 500°C bzw. kontinuierlich im Durchziehofen bei Temperaturen von 450° bis 600° C.

An den letzten Kaltwalzstich schließt sich vorzugsweise eine Anlaßbehandlung bei den vorstehend genannten Temperaturen an. Die erfindungsgemäße Legierung kann also auf einfache Weise mit den in der Halbzeugindustrie üblichen Verfahrensschritten, wie Gießen, Warmumformen, Kaltumformen, Zwischenglühen, Kaltumformen, Schlußglühen – also insbesondere ohne Abschreckbehandlung – hergestellt werden. Die Glühzeiten bewegen sich dabei in den üblichen Grenzen, so daß auch kontinuierlich arbeitende Öfen mit relativ kurzen Verweilzeiten der Bänder auf hohen Temperaturen eingesetzt werden können.

Die erfindungsgemäße Kupfer-Chrom-Titan-Silizium-Legierung wird vorzugsweise als Werkstoff für elektronische Bauteile, Halbleiterträger für Transistoren, integrierte Schaltungen, für Steckverbinder und Teile für die Autoelektrik verwendet.

Eine erfindungsgemäße Legierung mit einem Titangehalt bis zu 0,099% wird für den genannten Zweck als Werkstoff verwendet, dessen elektrische Leitfähigkeit über 65% IACS liegt und dessen Brinell-Härte nach einer Glühbehandlung eines kaltverformten Bandes bei 1h/470°C über 115 HB bleibt. Eine Legierung mit einem Titangehalt von mehr als 0,099% wird als Werkstoff verwendet, dessen elektrische Leitfähigkeit zwischen 50 und 65% IACS liegt und dessen Brinell-Härte nach der geschilderten Glühbehandlung über 145 HB bleibt.

Eine Legierung mit einem Titangehalt bis 0,049% wird als Werkstoff verwendet, dessen elektrische Leitfähigkeit über 78% IACS liegt und dessen Brinell-Härte nach der beschriebenen Glühbehandlung über 115 HB bleibt.

Eine Legierung mit einem Titangehalt von mehr als 0,049% bis 0,099% wird als Werkstoff verwendet, dessen elektrische Leitfähigkeit zwischen 65 und 78% IACS liegt und dessen Brinell-Härte nach der beschriebenen Glühbehandlung über 130 HB bleibt.

Hierbei wurden die mechanischen Eigenschaften und das Erweichungsverhalten gemeinsam dadurch charakterisiert, daß man die Brinell-Härte (HB) nach einer einstündigen Glühung bei 470°C eines zuvor kaltverformten Bandes als Kenngröße annimmt.

Die Erfindung wird anhand des folgenden Ausführungsbeispiels näher erläutert:

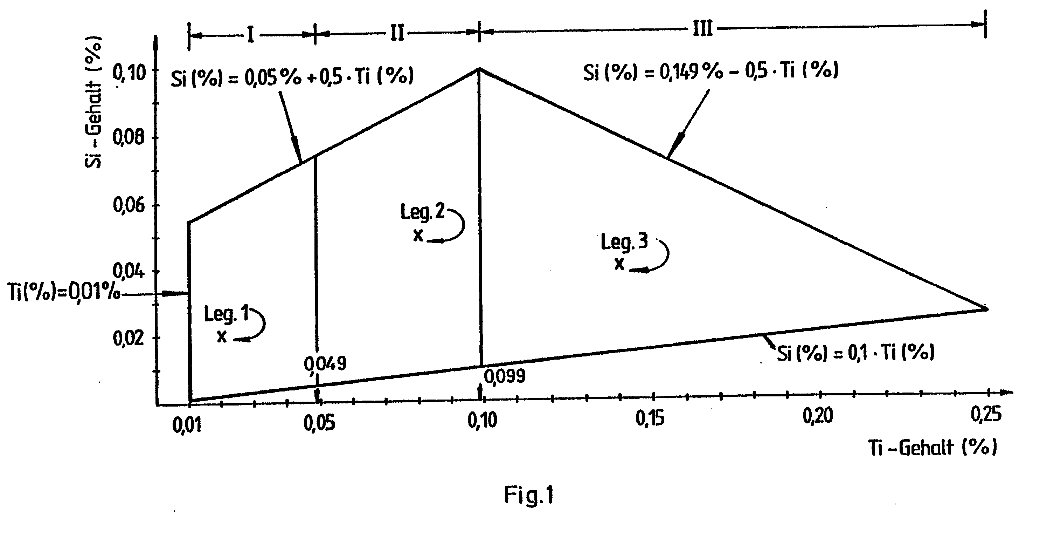

Hierbei ist zur Erläuterung im Diagramm nach Fig. 1 der Zusammenhang zwischen dem Titangehalt und dem Siliziumgehalt der erfindungsgemäßen Legierung dargestellt (der Chromgehalt bleibt dabei konstant). Der erfindungsgemäße Bereich ist durch die vier Geraden: Si (%) = 0,1 Ti (%), Si (%) = 0,05% + 0,5 Ti (%), Si (%) = 0,149% − 0,5 Ti (%) und Ti (%) = 0,01% abgegrenzt.

Tabelle 1 zeigt die Zusammensetzung dreier erfindungsgemäßer Legierungen (Nr. 1, 2, 3) aus den in Fig. 1 mit I, II, III gekennzeichneten Bereichen.

#### Tabelle 1: Zusammensetzung der Proben (Angaben in Gew.-%)

| Probenbezeichnung | Cr | Ti | Si | Cu |
|---|---|---|---|---|
| 1 | 0,33 | 0,02 | 0,02 | Rest |
| 2 | 0,28 | 0,08 | 0,05 | Rest |
| 3 | 0,29 | 0,14 | 0,04 | Rest |

Die drei Legierungen wurden betriebsmäßig hergestellt unter Anwendung der üblichen Schritte: Gießen, Anwärmen, Warmumformen, Abkühlen an Luft, Kaltwalzen und Zwischenglühen im Wechsel.

Dabei wurden die Gußblöcke bei 900°C in mehreren Stunden auf Warmwalztemperatur gebracht, warmgewalzt und kontinuierlich an Luft abgekühlt. Dem Kaltwalzen auf eine Zwischendicke von 4,0 mm folgte eine Glühbehandlung bei 470° C/1 h. Nach einer Schlußabwalzung an die gewünschte Enddicke (z.B. 0,254 mm) wurden die Zugfestigkeit, Brinell-Härte HB und die elektrische Leitfähigkeit ermittelt.

Die mechanischen und elektrischen Eigenschaften der Proben sind in Tabelle 2 zusammengestellt, zusammen mit den entsprechenden Werten für Legierungen aus dem Stand der Technik, welche der Literatur entnommen wurden (vgl. beispielsweise die Firmenschrift "Leadframe Materials from Tamagawa" (1983), insbesondere Seite 3, 4, 10, der Firma Tamagawa Metal & Machinery Co., Ltd.).

Tabelle 2: Elektrische und mechanische Eigenschaften (Zustand: 80% kaltverformt und angelassen, Banddicke 0,254 mm)

| Probenbe-zeichnung | (UNS-Bezeichnung) | Zugfestigkeit (N/mm$^2$) | Brinellhärte HB | Elektrische Leitfähigkeit (% IACS) |
|---|---|---|---|---|
| 1 | | 520 | 130 | 85 |
| 2 | | 560 | 144 | 78 |
| 3 | | 595 | 158 | 63 |
| CuFe2P | (C19400) | 480 | 128 | 65 |
| CuFeSnP | (C19520) | 540 | 147 | 48 |
| CuZn15 | (C23000) | 450 | 120 | 37 |

Es zeigt sich, daß die erfindungsgemäßen Legierungen 1 und 2 eine bedeutend höhere Leitfähigkeit als die Legierungen nach dem Stand der Technik aufweisen, während die Legierung 3 bei vergleichbarer Leitfähigkeit unübertroffene Festigkeits- und Härtewerte erreicht.

Die Legierungen im Bereich I der Fig. 1 sind durch sehr hohe elektrische Leitfähigkeiten von über 78% IACS und durch gute Festigkeiten (Brinell-Härte >115 HB), die Legierungen im Bereich II durch hohe elektrische Leitfähigkeiten im Bereich von 65 bis 78% IACS und durch gleichzeitig gute Festigkeiten (Brinell-Härte > 130 HB) und die Legierungen im Bereich III durch gute elektrische Leitfähigkeiten im Bereich von 50 bis 65% IACS und sehr hohe Festigkeiten (Brinell-Härte > 145 HB) gekennzeichnet.

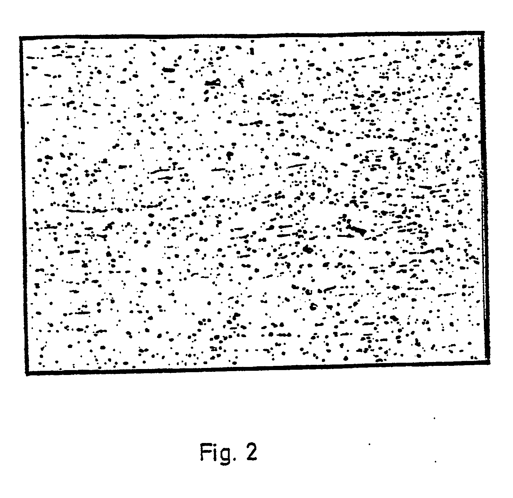

Die ausgezeichneten mechanischen und elektrischen Eigenschaften der erfindungsgemäßen Legierung ergeben sich durch extrem feine und homogen in der Kupfermatrix verteilte Ausscheidungen der beteiligten Legierungselemente Chrom, Titan und Silizium. Die Fig. 2 zeigt beispielsweise das Gefüge der erfindungsgemäßen Legierung 2 im angelassenen Zustand bei einer Vergrößerung von 1000 : 1. (Die Legierungen 1 bis 3 weisen nahezu ein identisches Gefüge auf.) Daraus ist ersichtlich, daß die sehr kleinen festigkeits- und leitfähigkeitssteigernden Ausscheidungsteilchen in der Größenordnung von 1 μm und darunter vorliegen.

Diese günstige Ausscheidungscharakteristik wird ohne die bei ausscheidungsbildenden Legierungen übliche spezielle Wärmebehandlung mit Wasserabschreckung und anschließendem Anlassen erreicht. Sie bildet sich bei der für naturharte Kupferlegierungen üblichen Fertigungsweise aus, die durch die Schritte Anwärmen, Warmumformen, Abkühlen an Luft, Kaltwalzen und Zwischenglühen im Wechsel gekennzeichnet ist. Die Legierung besitzt daher wesentliche fertigungstechnische Vorteile gegenüber den bisher bekannten Kupfer-Chrom-Silizium- bzw. Kupfer-Chrom-Titan-Legierungen.

Ohne Eigenschaftsverluste ist diese vereinfachte und damit billigere Fertigungsweise (ohne Abschreckbehandlung) nur mit der in den erfindungsgemäßen Legierungen vorhandenen Kombination der Legierungselemente und deren niedrigen Gehalten zu erreichen. Bei höheren Anteilen der Legierungselemente Chrom, Titan und Silizium als den der erfindungsgemäßen Legierung verschlechtert sich mindestens eine der genannten Eigenschaften, üblicherweise jedoch mehrere Eigenschaften gleichzeitig.

Eine besonders hervorzuhebende Eigenschaft der erfindungsgemäßen Legierung ist die gute Biegbarkeit. Auch im angelassenen Zustand sind bei höchsten Festigkeiten und Härten noch scharfkantige 90°-Biegungen sowohl senkrecht als auch parallel zur Walzrichtung ohne Rißbildung möglich. Dagegen weisen Kupfer-Chrom-Silizium- und Kupfer-Chrom-Titan-Legierungen der früher bekannten Zusammensetzung ein deutlich schlechteres Biegeverhalten auf. Für die ausgezeichnete Biegbarkeit der erfindungsgemäßen Legierungen sind ebenfalls die feinen und homogen verteilten Ausscheidungsteilchen verantwortlich, da diese eine Rißfortpflanzung ins Bandinnere offensichtlich verzögern bzw. verhindern. Metallographische Untersuchungen ergaben, daß ein sich bildender Anriß nicht senkrecht zur Bandoberfläche weiterläuft, sondern etwa parallel zur Bandoberfläche umgelenkt wird, so daß lediglich eine gewisse Narbigkeit aber kein echter Riß entsteht. Dieses Biegeverhalten ist besonders bei sogenannten oberflächenmontierten Bauelementen (SMD) = "surface-mounted devices" von großer Bedeutung, da die Anschlußbeinchen scharfkantig umgebogen werden und danach möglichst keine Rückfederung mehr zeigen sollen.

## Patentansprüche

1. Kupfer-Chrom-Titan-Silizium-Legierung, dadurch gekennzeichnet, daß sie aus 0,10 bis 0,50% Chrom; 0,01 bis 0,25% Titan; Silizium; Rest Kupfer und üblichen Verunreinigungen besteht, wobei der Siliziumgehalt mehr als das 0,1fache des Titangehalts beträgt und bis zu einem Titangehalt von 0,099% durch die Gleichung:

Siliziumgehalt (%) = 0,05% + 0,5 Titangehalt (%),
und bei einem Titangehalt von mehr als 0,099% durch die Gleichung:
Siliziumgehalt (%) = 0,149% − 0,5 Titangehalt (%)
begrenzt ist.

2. Kupfer-Chrom-Titan-Silizium-Legierung nach Anspruch 1,
dadurch gekennzeichnet, daß bis zu einem Titangehalt von 0,099% der Siliziumgehalt mehr als das 0,1fache des Titangehalts beträgt und durch die Gleichung:
Siliziumgehalt (%) = 0,05% + 0,5 Titangehalt (%)
begrenzt ist.

3. Kupfer-Chrom-Titan-Silizium-Legierung nach Anspruch 1, dadurch gekennzeichnet, daß bei einem Titangehalt von mehr als 0,099% der Siliziumgehalt mehr als das 0,1fache des Titangehalts beträgt und durch die Gleichung:
Siliziumgehalt (%) = 0,149% − 0,5 Titangehalt (%)
begrenzt ist.

4. Kupfer-Chrom-Titan-Silizium-Legierung nach Anspruch 2, dadurch gekennzeichnet, daß bis zu einem Titangehalt von 0,049% der Siliziumgehalt mehr als das 0,1fache des Titangehalts beträgt und durch die Gleichung:
Siliziumgehalt (%) = 0,05% + 0,5 Titangehalt (%)
begrenzt ist.

5. Kupfer-Chrom-Titan-Silizium-Legierung nach Anspruch 2, dadurch gekennzeichnet, daß bei einem Titangehalt von mehr als 0,049% bis 0,099% der Siliziumgehalt mehr als das 0,1fache des Titangehalts beträgt und durch die Gleichung:
Siliziumgehalt (%) = 0,05% + 0,5 Titangehalt (%)
begrenzt ist.

6. Verfahren zur Herstellung einer Kupfer-Chrom-Titan-Silizium-Legierung nach den Ansprüchen 1 bis 5, dadurch gekennzeichnet, daß die Legierung bei Temperaturen von 850° bis 950°C zwischen 1 und 24 Stunden homogenisiert, bei Temperaturen von 600° bis 830°C in einem oder mehreren Stichen warmgewalzt und mit einer Abkühlgeschwindigkeit zwischen 10°C pro Minute und 2000°C pro Minute auf Raumtemperatur abgekühlt wird.

7. Verfahren nach Anspruch 6, dadurch gekennzeichnet, daß bei Temperaturen von 650° bis 750°C warmgewalzt wird.

8. Verfahren nach Anspruch 6 oder 7, dadurch gekennzeichnet, daß mit einer Abkühlgeschwindigkeit zwischen 50°C pro Minute und 1000°C pro Minute abgekühlt wird.

9. Verfahren nach den Ansprüchen 6 bis 8, dadurch gekennzeichnet, daß nach dem Abkühlen mit einem Verformungsgrad bis zu 95% in einem oder mehreren Stichen kaltgewalzt wird.

10. Verfahren nach Anspruch 9, dadurch gekennzeichnet, daß zwischen den Kaltwalzstichen jeweils für weniger als 10 Stunden geglüht wird.

11. Verfahren nach Anspruch 9 oder 10, dadurch gekennzeichnet, daß auf den letzten Kaltwalzstich eine Anlaßbehandlung folgt.

12. Verwendung der Kupfer-Chrom-Titan-Silizium-Legierung nach Anspruch 1 als Werkstoff für elektronische Bauteile, Halbleiterträger für Transistoren, integrierte Schaltungen, für Steckverbinder und Teile für die Autoelektrik.

13. Verwendung einer Kupfer-Chrom-Titan-Silizium-Legierung nach Anspruch 2 als Werkstoff, dessen elektrische Leitfähigkeit über 65% IACS liegt und dessen Brinell-Härte nach einer Glühbehandlung eines kaltverformten Bandes bei 1h/470°C über 115 HB bleibt, für den Zweck nach Anspruch 12.

14. Verwendung einer Kupfer-Chrom-Titan-Silizium-Legierung nach Anspruch 3 als Werkstoff, dessen elektrische Leitfähigkeit zwischen 50 und 65% IACS liegt und dessen Brinell-Härte nach einer Glühbehandlung eines kaltverformten Bandes bei 1h/470°C über 145 HB bleibt, für den Zweck nach Anspruch 12.

15. Verwendung einer Kupfer-Chrom-Titan-Silizium-Legierung nach Anspruch 4 als Werkstoff, dessen elektrische Leitfähigkeit über 78% IACS liegt und dessen Brinell-Härte nach einer Glühbehandlung eines kaltverformten Bandes bei 1h/470°C über 115 HB bleibt, für den Zweck nach Anspruch 12.

16. Verwendung einer Kupfer-Chrom-Titan-Silizium-Legierung nach Anspruch 5 als Werkstoff, dessen elektrische Leitfähigkeit zwischen 65 und 78% IACS liegt und dessen Brinell-Härte nach einer Glühbehandlung eines kaltverformten Bandes bei 1h/470°C über 130 HB bleibt, für den Zweck nach Anspruch 12.

**Claims**

1. A copper-chromium-titanium-silicon alloy consisting of 0.10 to 0.50% chromium, 0.01 to 0.25% titanium, silicon, the balance being copper and the usual impurities, wherein the silicon content is more than 0.1 times the titanium content and, up to a titanium content of 0.099%, limited by the equation:
silicon content (%) = 0.05% + 0.5 titanium content (%), and,
for a titanium content of more than 0.099%, limited by the equation:
silicon content (%) = 0.149% − 0.5 titanium content (%).

2. A copper-chromium-titanium-silicon alloy according to Claim 1, wherein the silicon content is more than 0.1 times the titanium content for a titanium content of up to 0.099% and limited by the equation:
silicon content (%) = 0.05% + 0.5 titanium content (%).

3. A copper-chromium-titanium-silicon alloy according to Claim 1, wherein the silicon content is more than 0.1 times the titanium content, for a titanium content of more than 0.099%, and limited by the equation:
silicon content (%) = 0.149% − 0.5 titanium content (%).

4. A copper-chromium-titanium-silicon alloy according to Claim 2, wherein the silicon content is more than 0.1 times the titanium content, for a titanium content of up to 0.049%, and limited by the equation:
silicon content (%) = 0.05% + 0.5 titanium content (%).

5. A copper-chromium-titanium-silicon alloy according to Claim 2, wherein the silicon content is more than 0.1 times the titanium content, for a titanium content of 0.049 to 0.099%, and limited by the equation:
silicon content (%) = 0.05% + 0.5 titanium content (%).

6. A method of manufacture for a copper-chromium-titanium-silicon alloy according to Claims 1 through 5, wherein the alloy is homogenized at a temperature of 850° to 950°C for 1 to 24 hours, hot rolled at a temperature of 600° to 830°C in one or several passes, and then cooled down to room temperature at a rate of between 10° and 2,000°C per minute.

7. A method according to Claim 6, wherein the hot rolling temperature is 650° to 750°C.

8. A method according to Claim 6 or 7, wherein the cooling rate is between 50°C and 1,000°C per minute.

9. A method according to Claims 6 to 8, wherein cooling is followed by cold rolling with a reduction of up to 95% in one or several passes.

10. A method according to Claim 9, wherein the material is annealed between the cold rolling passes for less than 10 hours each time.

11. A method according to Claim 9 or 10, wherein the last cold rolling pass is followed by tempering.

12. Use of a copper-chromium-titanium-silicon alloy according to Claim 1 for electronic components, leadframes for transistors, integrated circuits, connectors, and parts for automotive electrics.

13. Use of a copper-chromium-titanium-silicon alloy according to Claim 2 for the purpose according to Claim 12, wherein the electrical conductivity of the alloy lies above 65% IACS, and the Brinell hardness remains above 115 HB after an annealing treatment for 1 hour at 470°C of a cold formed strip.

14. Use of a copper-chromium-titanium-silicon alloy according to Claim 3 for the purpose according to Claim 12, wherein the electrical conductivity of the alloy ranges from 50 to 65% IACS, and the Brinell hardness remains above 145 HB after an annealing treatment for 1 hour at 470°C of a cold formed strip.

15. Use of a copper-chromium-titanium-silicon alloy according to Claim 4 for the purpose according to Claim 12, wherein the electrical conductivity of the alloy lies above 78% IACS, and the Brinell hardness remains above 115 HB after an annealing treatment for 1 hour at 470°C of a cold formed strip.

16. Use of a copper-chromium-titanium-silicon alloy according to Claim 5 for the purpose according to Claim 12, wherein the electrical conductivity of the alloy ranges from 65 to 78% IACS and the Brinell hardness remains above 130 HB after an annealing treatment for 1 hour at 470°C of a cold formed strip.

**Revendications**

1. Alliage cuivre-chrome-titane-silicium, caractérisé en ce qu'il se compose de 0,10 à 0,50% de chrome; de 0,01 à 0,25% de titane; de silicium; le reste étant constitué par du cuivre et par les impuretés habituelles, la teneur en silicium étant supérieure à 0,1 fois la teneur en titane et étant limitée, jusqu'à une teneur en titane de 0,099%, par l'équation:
teneur en silicium (%) = 0,05% + 0,5 teneur en titane (%), et, pour une teneur en titane de plus de 0,099%, par l'équation:
teneur en silicium (%) = 0,149% − 0,5 teneur en titane (%).

2. Alliage cuivre-chrome-titane-silicium selon la revendication 1, caractérisé en ce que, jusqu'à une teneur en titane de 0,099%, la teneur en silicium est plus de 0,1 fois la teneur en titane et est limitée par l'équation:
teneur en silicium (%) = 0,05% + 0,5 teneur en titane (%).

3. Alliage cuivre-chrome-titane-silicium selon la revendication 1, caractérisé en ce que, pour une teneur en titane de plus de 0,099%, la teneur en silicium est plus de 0,1 fois la teneur en titane et est limitée par l'équation:
teneur en silicium (%) = 0,149% − 0,5 teneur en titane (%).

4. Alliage cuivre-chrome-titane-silicium selon la revendication 2, caractérisé en ce que, jusqu'à une teneur en titane de 0,049%, la teneur en silicium est plus de 0,1 fois la teneur en titane et est limitée par l'équation:
teneur en silicium (%) = 0,05% + 0,5 teneur en titane (%).

5. Alliage cuivre-chrome-titane-silicium selon la revendication 2, caractérisé en ce que, pour une teneur en titane de plus de 0,049% à 0,099%, la teneur en silicium est plus de 0,1 fois la teneur en titane et est limitée par l'équation:
teneur en silicium (%) = 0,05% + 0,5 teneur en titane (%).

6. Procédé de fabrication d'un alliage cuivre-chrome-titane-silicium selon les revendications 1 à 5, caractérisé en ce qu'on homogénéise l'alliage à une température de 850° à 950°C entre 1 et 24 heures, on le lamine à chaud à une température de 600° à 830°C en une ou plusieurs passes, et on le refroidit à la température ambiante à une vitesse de refroidissement comprise entre 10°C par minute et 2000°C par minute.

7. Procédé selon la revendication 6, caractérisé en ce qu'on lamine à chaud à une température de 650° à 750°C.

8. Procédé selon la revendication 6 ou 7, caractérisé en ce qu'on refroidit à une vitesse comprise entre 50°C par minute et 1000°C par minute.

9. Procédé selon les revendications 6 à 8, caractérisé en ce que, après le refroidissement, on lamine à froid, en une ou plusieurs passes, avec un degré de déformation atteignant jusqu'à 95%.

10. Procédé selon la revendication 9, caractérisé en ce que, entre les passes de laminage à froid, on recuit chaque fois pendant moins de 10 heures.

11. Procédé selon la revendication 9 ou 10, caractérisé en ce que la dernière passe de laminage à froid est suivie d'un traitement de revenu.

12. Utilisation de l'alliage cuivre-chrome-titane-silicium selon la revendication 1 comme matériau pour des composants électroniques, en particulier des semi-conducteurs pour transistors, circuits intégrés ou similaires, des connecteurs et des pièces d'électricité automobile.

13. Utilisation d'un alliage cuivre-chrome-titane-silicium selon la revendication 2 comme matériau dont la conductivité électrique est supérieure à 65% IACS et dont la dureté Brinell reste supérieure à 115 HB après traitement de recuit d'une bande écrouie pendant 1 heure à 470°C, pour le but selon la revendication 12.

14. Utilisation d'un alliage cuivre-chrome-titane-silicium selon la revendication 3 comme matériau dont la conductivité électrique est comprise entre 50 et 65% IACS et dont la dureté Brinell reste supérieure à 145 HB après traitement de recuit d'une bande écrouie pendant 1 heure à 470°C, pour le but selon la revendication 12.

15. Utilisation d'un alliage cuivre-chrome-titane-silicium selon la revendication 4 comme matériau dont la conductivité électrique est supérieure à 78% IACS et dont la dureté Brinell reste supérieure à 115 HB après traitement de recuit d'une bande écrouie pendant 1 heure à 470°C, pour le but selon la revendication 12.

16. Utilisation d'un alliage cuivre-chrome-titane-silicium selon la revendication 5 comme matériau dont la conductivité électrique est comprise entre 65 et 78% IACS et dont la dureté Brinell reste supérieure à 130 HB après traitement de recuit d'une bande écrouie pendant 1 heure à 470°C, pour le but selon la revendication 12.

Fig.1

Fig. 2